Europäisches Patentamt

European Patent Office

Office européen des brevets

(11) Publication number: 0 217 179
A2

# (12) EUROPEAN PATENT APPLICATION

(21) Application number: 86112421.2

(51) Int. Cl.⁴: H01L 21/268

(22) Date of filing: 08.09.86

(30) Priority: 30.09.85 US 781867

(43) Date of publication of application:
08.04.87 Bulletin 87/15

(84) Designated Contracting States:
DE FR GB IT

(71) Applicant: ALLIED CORPORATION
Columbia Road and Park Avenue P.O. Box
2245R (Law Dept.)
Morristown New Jersey 07960(US)

(72) Inventor: Rivier, Michel c/o Allied Corporation
P.O. Box 5060 20650 Civic Center Drive
Southfield Michigan 48-86(US)
Inventor: Cserhati, Andras Fabricius c/o
Allied Corporation
P.O. Box 5060 20650 Civic Center Drive
Southfield Michigan 48-86(US)
Inventor: Goetz, George Gabriel c/o Allied
Corporation
P.O. Box 5060 20650 Civic Center Drive
Southfield Michigan 48-86(US)

(74) Representative: Brullé, Jean et al
Service Brevets Bendix 44, rue François 1er
F-75008 Paris(FR)

(54) A method for laser crystallization of semiconductor islands on transparent substrates.

(57) A method for laser crystallization of semiconductor islands (10) on a transparent substrate (12) in which a portion of the surface of the semiconductor islands (10) along the edges (16 and 18) are covered with a layer (14) of transparent material. The thickness of the transparent layer (14) being selected to enhance the absorption of the laser energy by the semiconductor material at the edges (16 and 18) of the islands (10) compensating for edge losses and increasing the uniformity of the crystallization.

Fig-1

# A METHOD FOR LASER CRYSTALLIZATION OF SEMICONDUCTOR ISLANDS ON TRANSPARENT SUBSTRATES

## Field of the Invention

The invention is related to the field of processing semiconductor devices and, in particular, to a method for laser crystallization of semiconductor islands disposed on a transparent substrate.

## Prior Art

It is well known in the art that amorphous semiconductor films deposited or formed on transparent non-semiconductor substrates can be crystallized by laser radiation. Further the prior art teaches that subdividing of amorphous semiconductor film into a plurality of discrete islands before crystallization avoids cracking due to a mismatch between the coefficients of thermal expansion of the crystallized semiconductor film and the substrate. The prior art has also shown that shaping of the islands enhances nucleation and crystal growth by defining appropriate thermal gradients and that capping the semiconductor islands with a layer of transparent material prevents agglomeration of the semiconductor material while in the liquid state. Finally, J. P. Colinge and F. VandeWiele in their paper "Laser Light Absorption in Multilayers" J. Applied Physics, Vol. 52, No. 7, July 1981 teach that the laser energy coupled to the semiconductor islands can be enhanced by using transparent layers of a proper thicknes overlaying the semiconductor island. Effectively Colinge and VandeWiele teach that by appropriate control of the thickness of the transparent layer, it can function as a antireflection layer reducing energy losses due to reflections.

One of the problems faced with laser crystallization of the semiconductor islands on transparent substrates is maintaining a uniform temperature across the island during crystallization. Since the transparent substrate does not absorb the laser energy, it remains relatively cold during the crystallization process. This produces a thermal gradient near the edges of the island in which the edges are cooler than the central portion. The crystallization at the cooler edges results in the formation of crystals having smaller than desired grain size.

One solution to this problem is taught by Biegesen et al in U.S. Patent 4,330,363 in which a continuous thin layer of silicon and an antireflection coating are disposed under the semiconductor islands. The portions of the continuous silicon layer between the semiconductor islands will also be heated by the laser, thereby providing a uniform thermal gradient across the islands. This process, however, loses most of the advantages of a silicon on insulator (SOI) structure in terms of lower capacitance created by the insulator substrate.

The invention is a novel approach to the edge effect problem which is less complex and does not require the deposition of material intermediate the transparent substrate and the semiconductor islands.

## Summary of the Invention

The invention is a method for the laser crystallization of semiconductor islands on the surface of a transparent insulator substrate characterized by the steps of depositing a layer of transparent material on the surface of the semiconductor islands covering a predetermined portion of each of said semiconductor islands along at least two opposing edges, the thickness of said layer of transparent material selected to reduce reflections from the underlying surfaces of the semiconductor islands and scanning said semiconductor islands including the portions underlying said layer of transparent material with a laser beam to crystallize said semiconductor islands. In the preferred embodiment, a second layer of transparent material is deposited over the remainder of the surface of each semiconductor island. The second layer of transparent material having a thickness selected to not inhibit the reflection of the laser beam from the surface of the semiconductor islands.

The advantage of this laser crystallization method is that the antireflection coatings along the edges of the semiconductor islands increases the energy absorption in these regions compensating for the heat losses at the edges. Another advantage is that the antireflection coatings are relatively easy to remove and do not increase the capacitance between circuit elements. These and other advantages will become more apparent from a reading of the detailed description of the invention in conjunction with the drawings.

## Brief Description of the Drawings

FIGURE I is a cross-sectional view of the substrate, semiconductor island and antireflection coating.

FIGURE 2 is a top view of the structure of FIGURE I.

FIGURE 3 is a cross-sectional view of the structural arrangement of the semiconductor island, antireflection coating and encapsulating coating disposed on the surface of the substrate.

FIGURE 4 is a top view of the structural arrangement of FIGURE 3.

FIGURE 5 is a graph depicting the temperature profile taken across the island during laser crystallization.

Detailed Description of the Invention

The dielectric pattern used to control the temperature distribution of the semiconductor island on a transparent substrate is illustrated in FIGURES I and 2. An amorphous semiconductor island 10, such as a silicon island, is formed on a transparent insulator substrate 12, such as glass, quartz or any other suitable transparent material used in the fabrication of solid state devices. The semiconductor island 10 can be formed using any of the techniques known in the art. The semiconductor island 10 may be a solitary island or may be one of many semiconductor islands depending upon the application. The islands 10 may be square, rectangular or any other suitable geometric shape and their size may vary from a few 10's of micron to much larger sizes and have a thickness ranging up to 20.0 microns.

An antireflection coating 14 is then deposited over the edges of the semiconductor islands and extending onto the transparent substrate 12 as shown using conventional photolithographic techniques. Preferably, the antireflection coating 14 will be deposited over all four edges of the silicon island 10. However, when the silicon island 10 is rectangular and its length is substantially longer than its width, the antireflection coating may be applied only over the opposing long edges, such as edges 16 and 18 of the silicon island 10. The antireflection coating 14 may be any suitable transparent material such as silicon dioxide ($SiO_2$), aluminum oxide ($Al_2O_3$), silicon nitride ($Si_3N_4$) or a combination thereof. The thickness of the antireflection coating 14 is selected to reduce to a minimum the reflections of the incident radiation such as a scanning laser beam 20 which scans across the surface of the semiconductor island 10 in the direction shown by arrows 22. Depending upon the width of the semiconductor island 10, the laser crystallization may be by a single scan or by multiple overlapping parallel scans.

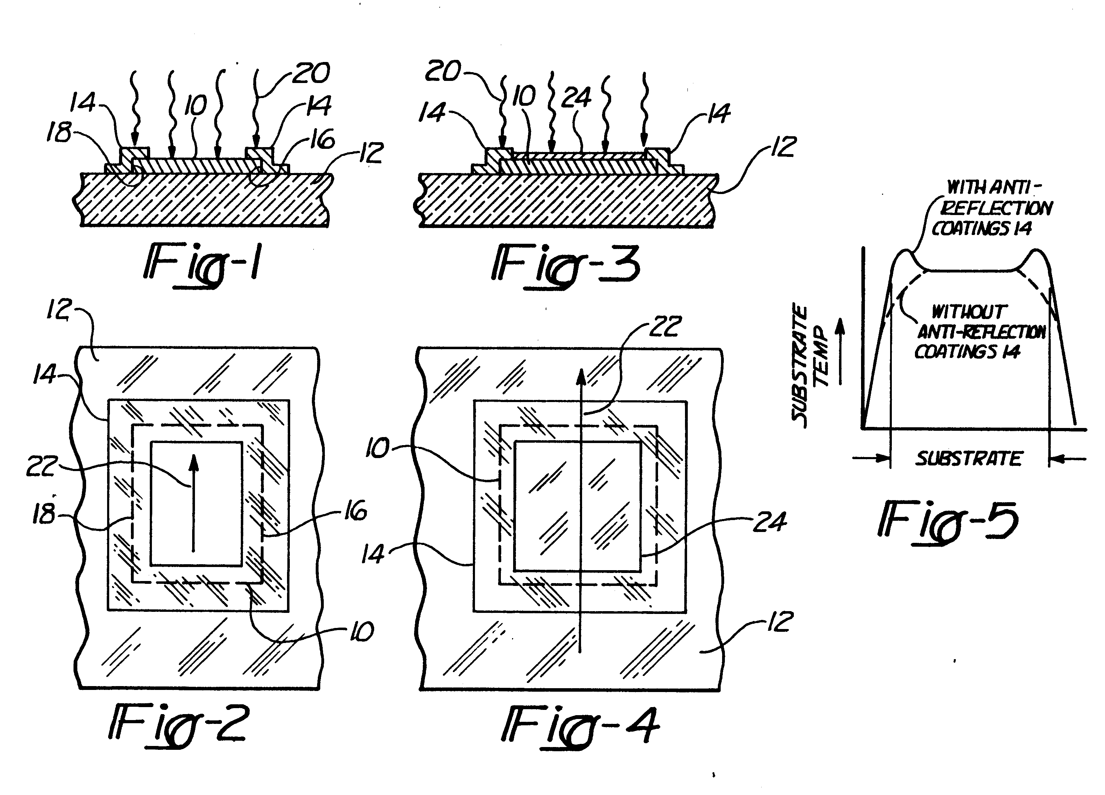

The thickness of the antireflection coating will depend primarily upon its index of refraction and the wavelength of the laser. For example, a 600 Angstrom layer of silicon nitride ($Si_3N_4$) substantially reduces the reflections of the energy from an Argon ion laser from the surface of a silicon island and provides the largest reflectivity difference between the uncoated portion and the antireflection coated portions of the island. The function of the antireflection coating is to minimize the amount of incident radiation reflected from the region of the semiconductor island adjacent to its edges. Accordingly, a greater amount of the incident radiant energy will be absorbed at the edges, as shown in FIGURE 5, compensating for the higher heat losses adjacent to the edges of the semiconductor island 10 as previously discussed. The increased energy absorption at the edges of the island will cause an increase in the temperature of the semiconductor material under the antireflection coatings 14. This will assure crystallization of the semiconductor material from the center of the island to the edges.

A 25 watt argon ion laser operating in the multiline mode was found to have sufficient power to completely melt the semiconductor island and produce the desired crystallization. The strongest lines of the argon ion laser are the blue (4880A) and green (5145A) lines which lie in the visible spectrum. Since the substrate 12 and the antireflection coating material are transparent to these wavelengths, the only element of the structure capable of absorbing the incident laser radiation is the semiconductor island 10.

It is recognized that other lasers, having different spectral emission characteristics, may be used in place of the argon ion laser. When using these different lasers, the antireflection coating material will have to be selected from materials transparent to the wavelengths emitted by these lasers. Further the thickness of the antireflection coating will have to be changed accordingly to achieve desired antireflection characteristics as is known in the art.

An alternate embodiment of the antireflecting coating is illustrated in FIGURES 3 and 4. As in the previous embodiment, the semiconductor island 10 is deposited on a transparent substrate 12 and the antireflecting coatings 14 are deposited over the edges of the semiconductor island 10 as previously described. In addition to the antireflection coatings 14, the remaining portion of the island 10 is overlaid with a transparent layer 24 to totally encapsulate the semiconductor island. The transparent layer 24, as is known in the art, will prevent the agglomeration of the semiconductor material during crystallization when it is in its liquid state. The material of the transparent layer 24 may be the same as the material of the antireflection coating 14 or may be

an altogether different material. The thickness of the transparent layer 24 is selected to be different fom the thickness of the antireflection coating 14 so that it does not inhibit the reflection of the laser energy from the surface of the semiconductor island. The thickness of the transparent layer may be adjusted such that the temperature of the semiconductor material at the edges of the semiconductor island 10 is slightly higher than the temperature of the semiconducting material in the central region of the semiconductor island 10. This again will assure that crystallization of the entire semiconductor island proceeds from a single nucleus.

It is not intended that the ivention be limited to the geometry, the materials, or laser, shown in the drawings and described in the detailed description of the invention. It is recognized that persons skilled in the art may make changes without departing from the spirit of the invention as described herein and set forth in the appended claims.

## Claims

1. In a method for the laser crystallization of semiconductor islands (10) disposed on the surface of a transparent substrate (12), an improvement characterized by:

depositing a layer (14) of transparent material on the surface of said semiconductor islands (10) covering a predetermined portion of each of said semiconductor islands (10) along at least two opposing edges (16 and 18), the thickness of said layer of transparent material (14) selected to reduce reflections from the underlying surfaces of the semiconductor islands (10), and

scanning said semiconductor islands (10), including the portions underlying said layer (14) of transparent material with laser to crystallize said semiconductor islands (10).

2. The method of Claim 1 further characterized by said step of depositing a layer (14) of transparent material including the step of depositing a layer (24) of transparent material over the remaining surface of said semiconductor islands said transparent material deposited over the remaining surface having a thickness selected not to inhibit the reflection of said laser from the surface of the semiconductor island (10).

3. A method for uniformly crystallizing a semiconductor material disposed on the surface of a transparent substrate (12) including the step of:

depositing semiconductor material on the surface of a transparent substrate to form at least one island (10) and characterized by the steps of:

depositing a transparent material (14) on the surface of said semiconductor material to form antireflection coatings covering predetermined portions of said semiconductor material adjacent to at least two opposing edges (16 and 18) of said at least one island (10); and

scanning said at least one island (10) with a radiant energy source to crystallize said semiconductor material.

4. The method of Claim 3 further characterized by said step of depositing semiconductor material including the step of depositing said semiconductor material to a thickness ranging from .025 to 20.0 microns.

5. The method of Claim 3 further characterized by said radiant energy source including a laser.

6. The method of Claim 3 further characterized by said step of depositing a transparent material - (14) including the step of depositing a transparent material (24) over the central portion of said island (10) between said antireflection coatings (14) to encapsulate said island (10) of semiconductor material, the thickness of said transparent material - (24) deposited on said central portion selected not to inhibit the reflection of the radiant energy from said central portion of said island (10).

7. The method of Claim 4 further characterized by said step of depositing a transparent material - (14) including the step of depositing a transparent material (24) over the central portion of said island (10) between said antireflection coatings (14) to encapsulate said island (10) of semiconductor material, the thickness of said transparent material - (24) deposited on said central portion selected not to inhibit the reflection of the radiant energy from said central portion of said island (10).

8. The method of Claim 3 further characterized by said transparent material (14) including oxide.

9. The method of Claim 3 further characterized by said transparent material (14) including silicon nitride.

10. The method of Claim 3 further characterized by said transparent material (14) including a combination of at least two transparent materials selected from the group comprising silicon dioxide, aluminum oxide and silicon nitride.

**Fig-1**

**Fig-3**

**Fig-2**

**Fig-4**

WITH ANTI-REFLECTION COATINGS 14

WITHOUT ANTI-REFLECTION COATINGS 14

SUBSTRATE TEMP

SUBSTRATE

**Fig-5**

0 217 179